# EUROPÄISCHE PATENTSCHRIFT

(11) **EP 4 607 158 B1**
(45) Veröffentlichungstag und Bekanntmachung des Hinweises auf die Patenterteilung: **08.07.2026**
(21) Anmeldenummer: 25157564.3
(22) Anmeldetag: 13.02.2025
(51) Int. Cl.: G01F 15/14, G01D 11/26, G01D 4/02, G01F 15/06

(54) **ANZEIGEEINRICHTUNG SOWIE ZÄHLER UMFASSEND EINE SOLCHE ANZEIGEEINRICHTUNG**
DISPLAY DEVICE AND COUNTER COMPRISING SUCH A DISPLAY DEVICE
DISPOSITIF D'AFFICHAGE ET COMPTEUR COMPRENANT UN TEL DISPOSITIF D'AFFICHAGE

(30) Priorität: 20.02.2024 DE 102024104753
(43) Veröffentlichungstag der Anmeldung: 27.08.2025
(73) Patentinhaber: Diehl Metering GmbH, 91522 Ansbach (DE)
(72) Erfinder: Gronauer, Christoph, 90602 Pyrbaum (DE); Riegel, Herbert, 91617 Oberdachstetten (DE); Hünenberger, Patrick, 91522 Ansbach (DE)
(74) Vertreter: Diehl Patentabteilung

(56) Entgegenhaltungen:
- WO-A1-2023/030772
- CN-A- 111 141 339
- US-A1- 2013 094 125

## Beschreibung

Die Erfindung betrifft eine Anzeigeeinrichtung, umfassend eine Trägerplatte mit einem oder mehreren darauf angeordneten elektronischen Bauteilen, einen Träger für ein Anzeigedisplay, ein am Träger angeordnetes Anzeigedisplay sowie eine Abdeckhaube, die zumindest in einem das Anzeigedisplay übergreifenden Bereich transparent ist, wobei unterhalb der Abdeckhaube ein abgedichteter Hohlraum, in dem das Anzeigedisplay aufgenommen ist, ausgebildet ist.

Eine solche Anzeigeeinrichtung dient der Anzeige unterschiedlicher Informationen, beispielsweise von Messwerten. Sie ist beispielsweise Teil einer Zählereinrichtung wie eines Wasserzählers, Stromzählers, Gaszählers und ähnliches. Auch kann sie Teil einer Fertigungsmaschine sein und der Anzeige von Betriebsparametern oder sonstigen Werten dienen. Weitere Einsatzmöglichkeiten sind denkbar, die Aufzählung ist nicht abschließend.

Die Anzeigeeinrichtung ist üblicherweise ein separates, vorgefertigtes Bauteil, das in geeigneter Weise mit der zugeordneten Vorrichtung sowohl mechanisch als auch elektrisch verbunden wird. Sie weist regelmäßig eine Trägerplatte auf, zumeist in Form einer Leiterplatine, an der ein oder mehrere elektronische Bauteile, beispielsweise eine Batterie oder ein Akkumulator, Widerstände, Kondensatoren, Speicherchips, Prozessoren etc. angeordnet sind. Des Weiteren ist ein Träger vorgesehen, an dem ein Anzeigedisplay, beispielsweise ein LCD-Display, angeordnet ist, an dem die auszugebenden Daten angezeigt werden. Das Anzeigedisplay ist unterhalb einer Abdeckhaube angeordnet, die den Träger samt dem Anzeigedisplay, aber auch die Trägerplatte samt dem oder den Bauteilen übergreift. Die Abdeckhaube ist zumindest in dem Bereich, der das Anzeigedisplay übergreift, transparent, sie kann aber insgesamt aus einem transparenten Material, regelmäßig Kunststoff, gefertigt sein. Das Anzeigedisplay befindet sich eng benachbart unterhalb der Abdeckhaube bzw. des transparenten Bereichs, sodass es bestmöglich durch den transparenten Bereich sichtbar ist. Dabei ist unterhalb der Abdeckhaube beziehungsweise unterhalb des transparenten Bereichs ein abgedichteter Hohlraum ausgebildet, in dem das Anzeigedisplay aufgenommen ist. Denn der sonstige Bereich bzw. Raum zwischen der Abdeckhaube und der Trägerplatte wird regelmäßig mit einer Vergussmasse vergossen. Dadurch, dass die Anzeigeeinrichtung in dem abgedichteten Hohlraum angeordnet ist, wird sie nicht in die Vergussmasse eingebettet, d. h., dass die Vergussmasse nicht in den Bereich zwischen Abdeckhaube und Anzeigeeinrichtung dringen kann, wohl aber den sonstigen Raum ausfüllen kann. Die Ausbildung des Hohlraums, in dem die Anzeigeeinrichtung angeordnet ist, erfolgt bisher dadurch, dass auf der Abdeckhaube ein aushärtendes Dichtmittel aufgebracht wird, das, wenn der Träger samt dem Anzeigedisplay montiert wird bzw. die Abdeckhaube aufgesetzt wird, den Spalt zwischen dem Träger und der Abdeckhaube schließt, sodass sich ein geschlossener Hohlraum ergibt, der einerseits über den transparenten Bereich der Abdeckhaube, andererseits durch den Träger sowie das dazwischen befindliche Dichtmittel gebildet wird. Es wird also mit einer geeigneten Applikationsvorrichtung eine Raupe aus dem pastösen Dichtmittel auf den Träger aufgebracht, die die Anzeigeeinrichtung randseitig vollständig umgibt. Dies ist aufwendig, da mit dem Aufbringen ein separater Arbeitsschritt verbunden ist, wie auch eine entsprechende Applikationsvorrichtung vorgesehen werden muss. Auch muss das Dichtmittel zur Sicherstellung der Dichtheit aushärten. Wird die Dichtmittelraupe fehlerhaft aufgebracht, besteht die Gefahr, dass der Hohlraum nicht ausreichend abgedichtet ist und die bis an das Dichtmittel anströmende Vergussmasse eindringen kann. US2013094125-A1 offenbart ein versiegeltes elektronisches Zähler-Register-Baugruppe, deren Gehäuse aus Kunststoff besteht und an der Unterseite offen bleibt. Ein transparenter Fensterdeckel wird in die obere Gehäusewand eingeschnappt; zwischen dem Fenster und dem darunter liegenden elektronischen numerischen Display befindet sich ein Gummidichtungspaket. Das Display wird von einem Rahmen getragen, der in seiner Mittelregion eine Öffnung aufweist; in dieser Öffnung wird ein weiches, polyurethan-basiertes Dichtmittel injiziert, das das Display von der Unterseite des Rahmens trennt. Anschließend wird ein hartes, zweikomponentiges Epoxid-Dichtmittel in die übrigen Hohlräume des Gehäuses eingespritzt, um die Schaltung, die Batterie und das Display zu umschließen.

Der Erfindung liegt das Problem zugrunde, eine verbesserte Anzeigeeinrichtung anzugeben.

Zur Lösung des Problems ist bei einer Anzeigeeinrichtung der eingangs genannten Art erfindungsgemäß vorgesehen, dass der Träger in einer Dichtanlage direkt an der Abdeckhaube anliegt und zwischen der Abdeckhaube und dem Träger der abgedichtete Hohlraum, in dem das Anzeigedisplay angeordnet ist, gebildet ist, wobei der außerhalb des Hohlraums gegebene Raum zwischen der Trägerplatte und der Abdeckhaube mit einer Vergussmasse gefüllt ist.

Bei der erfindungsgemäßen Anzeigeeinrichtung wird der abgedichtete Hohlraum, in dem die Anzeigeeinrichtung aufgenommen ist, allein zwischen der Abdeckhaube und dem Träger ausgebildet. Hierzu liegt der Träger in einer Dichtanlage direkt an der Abdeckhaube an, d. h., dass ein direkter Dichtkontakt zwischen dem Träger und der Abdeckhaube gegeben ist. Oberseitig wird der Hohlraum über die Abdeckhaube geschlossen, unterseitig über den flächigen, plattenförmigen Träger, der ebenfalls nach Art einer Wand oder eines Bodens den Hohlraum begrenzt. Durch den direkten Dichtkontakt zwischen dem Träger und der Abdeckhaube ist eine Abdichtung zwischen dem Träger und der Abdeckhaube allein über den mechanischen Kontakt bzw. die Dichtanlage gegeben, ein zusätzliches Dichtmittel, wie im Stand der Technik bisher üblich, ist daher bei der erfindungsgemäßen Anzeigeeinrichtung nicht erforderlich, was die Fertigung vereinfacht. Denn es ist lediglich erforderlich, den Träger, nachdem der Träger beispielsweise in geeigneter Weise mit der Trägerplatte verbunden ist und die Anzeigeeinrichtung am Träger angeordnet ist, mit der Abdeckplatte in Kontakt zu bringen, was beispielsweise automatisch erfolgt, wenn die Abdeckhaube über die Trägerplatte samt Träger und Anzeigedisplay gestülpt wird. Es bildet sich automatisch der Dichtsitz aus und damit der abgedichtete Hohlraum, in dem die Anzeigeeinrichtung gekapselt aufgenommen ist.

Zur Ausbildung dieser Dichtanlage ist in Weiterbildung der Erfindung an der Abdeckhaube ein umlaufender Anlagebereich vorgesehen, an dem der Träger mit einem ebenfalls umlaufenden Dichtabschnitt anliegt. Der an der Seite, an der die Anzeigeeinrichtung aufgenommen ist, quasi plattenförmige und vorzugsweise rechteckige Träger weist also an einer geeigneten Position einen um den Umfang umlaufenden Dichtabschnitt auf, der für die Dichtanlage an der Abdeckhaube ausgestaltet ist. Ebenso weist die Abdeckhaube einen entsprechenden umlaufenden Anlagebereich auf, der für die Dichtanlage des Dichtabschnitts des Trägers ausgebildet ist. Beim Fügen der Abdeckhaube mit dem Träger wird automatisch der Dichtabschnitt in Kontakt mit dem Anlagebereich gebracht, worüber die Dichtanlage gegeben ist.

Bevorzugt ist hierbei der Anlagebereich über einen umlaufenden Falz gebildet, in denen der Träger mit einer den Dichtabschnitt bildenden Schulter eingreift. Der Dichtabschnitt in Form der Schulter liegt also an einer umlaufenden Wand oder einem Rand des Falzes an, worüber die Dichtanlage gebildet ist. Dabei ist bevorzugt ein formschlüssiger Eingriff der Schulter in den Falz, also des Dichtabschnitts in den Anlagebereich gegeben, sodass eine entsprechend große Kontaktfläche zwischen Träger und Abdeckhaube gegeben ist, die sicherstellt, dass eine großflächige Dichtanlage gegeben ist.

Dabei greift die Schulter bevorzugt mit einer Presspassung formschlüssig in den Falz ein. D. h., dass der Dichtabschnitt in den Anlagebereich eingepresst ist, d. h., die Schulter ist in dem Falz vorgespannt aufgenommen und der Dichtabschnitt gegen den Anlagebereich gepresst. Hierzu ist der Träger im Bereich des Dichtabschnitts mit einem leichten Übermaß, verglichen zum Maß des Anlagebereich der Abdeckhaube, ausgebildet. Das Übermaß beträgt beispielsweise 1/10 mm. Beim Fügen wird folglich die Schulter in den Falz eingepresst und über das Übermaß, verbunden mit einer minimalen Verformung des Dichtabschnitts, der Pressverbund ausgebildet.

Dabei kann der Falz und/oder der Träger zumindest im Bereich des Dichtabschnitts eine Schrägfläche aufweisen. Diese Schrägfläche, die auch beidseits vorgesehen sein kann, erlaubt ein erleichtertes Einschieben und stellt gleichzeitig eine hinreichende Anlagekraft für einen festen Formschluss in der Montageentstellung sicher.

Der Träger selbst ist bevorzugt aus Kunststoff, also aus einem eine gewisse Weichheit aufweisenden Material, was zweckmäßig für die Dichtanlage respektive die Ausbildung der Presspassung ist. Natürlich ist auch die Abdeckhaube bevorzugt aus einem Kunststoff gefertigt, jedoch aus Stabilitätsgründen aus einem relativ harten Kunststoff. Grundsätzlich können sowohl der Träger als auch die Abdeckhaube aus beliebigen Kunststoffen gefertigt sein.

Dabei ist es denkbar, dass der Träger am Dichtabschnitt einen Belag aufweist, der etwas weicher als der den Träger bildende Kunststoff ist. D. h., dass der Träger am Dichtabschnitt eine aufgebrachte Kunststoff-Weichkomponente aufweist, die als dünner Belag aufgebracht ist und die Dichtebene bzw. die unmittelbare Kontaktfläche zum Anlagebereich der Abdeckhaube bildet. Der Träger ist also im Bereich des Dichtabschnitts als 2-Komponenten-Bauteil ausgebildet, wobei der den Belag bildende, weichere Kunststoff beispielsweise in einem 2K-Verfahren unmittelbar bei der Herstellung des ebenfalls aus Kunststoff gefertigten Trägers angeformt bzw. angespritzt werden kann.

Alternativ oder zusätzlich ist es denkbar, dass auch die Abdeckhaube im Anlagebereich einen Belag aufweist, der weicher als der Kunststoff, aus dem die Abdeckhaube gebildet ist, ist. Auch hier kann also ein entsprechend dünner Belag, der die Dichtebene bildet und am Dichtabschnitt des Trägers anliegt, vorgesehen sein. Die Abdeckhaube ist wie beschrieben regelmäßig aus Kunststoff, beispielsweise PMMA, sodass auch hier in einem 2K-Verfahren der weichere Belag unmittelbar bei der Herstellung der Abdeckhaube mit angespritzt werden kann.

Wie beschrieben, ist das Anzeigedisplay in geeigneter Weise mit einer zugeordneten Elektronik zu verbinden, worüber einerseits die Leistungsversorgung erfolgt, andererseits aber auch die entsprechenden, anzuzeigenden Signale bzw. Daten übertragen werden. Hierzu weist die Anzeigeeinrichtung üblicherweise mehrere Kontaktstifte, auch Kontaktpins genannt, auf. Um diese nun auf einfache Weise zur Trägerplatte zu führen und dort mit Leiterbahnen oder ähnlichem in Kontakt zu bringen, sieht eine besonders vorteilhafte Weiterbildung der Erfindung vor, dass der Träger einen oder mehrere Kanäle aufweist, durch die die Kontaktstifte des Anzeigedisplays laufen. Die Kontaktstifte, die zumeist unter einem Winkel von 90° von dem scheibenförmigen Anzeigedisplay abragen, laufen also durch den oder die Kanäle und treten an deren Ende aus, sodass sie im Bereich der austretenden Enden mit den Leiterbahnen etc. kontaktiert werden können. Hierzu durchgreifen die Kontaktstifte beispielsweise Durchbrechungen in der Trägerplatte, im Bereich welche Durchbrechungen der eigentliche Kontakt gegeben ist. Die Kanäle sind dabei sehr schmal ausgeführt, weisen also einen sehr kleinen Querschnitt auf, der ein Einführen und Durchführen der Kontaktstifte in und durch den Kanal erlaubt, jedoch zumindest abschnittsweise nicht allzu viel größer ist als der Querschnitt der Kontaktstifte. Hierüber wird sichergestellt, dass die Vergussmasse zwar etwas in einen solchen Kanal eindringen kann, jedoch nicht allzu weit in den Kanal eindringen kann. Denn in dem Kanal, der zwangsläufig mit dem Hohlraum, in dem das Anzeigedisplay angeordnet ist, verbunden ist, wird infolge des Eindringens der Vergussmasse ein leichter Überdruck aufgebaut, der dem weiteren Eindringen der Vergussmasse entgegenwirkt, sodass diese nur bis zu einem bestimmten Niveau im Kanal fließen kann, das jedoch deutlich unterhalb der Ebene, in der die Anzeigeeinrichtung positioniert ist, liegt.

Dabei ist es zweckmäßig, wenn sich der Querschnitt des oder der Kanäle zu einer Austrittsöffnung, aus der die Kontaktstifte Austreten, verjüngt. Eine solche Verjüngung, beispielsweise mit schräg zusammenlaufendem Querschnitt, erlaubt ein einfaches Einfädeln der Kontaktstifte, die von oben in den weiteren Querschnitt des oder der Kanäle eingefädelt werden und infolge der Verjüngung automatisch zur Austrittsöffnung geführt werden können. Durch die im Querschnitt nur geringfügig größere Austrittsöffnung oder Austrittsöffnungen wird bereits ein Eindringen von allzu viel Vergussmasse verhindert, ein weiteres Aufsteigen im Kanal durch den sich bildenden, geringen Überdruck verhindert, wie vorstehend bereits beschrieben.

Ferner kann vorgesehen sein, dass in dem Hohlraum ein Feuchtigkeit bindendes Trocknungsmittel aufgenommen ist. Über dieses Trocknungsmittel kann etwaige vorhandene Feuchtigkeit im Hohlraum gebunden werden, z.B. durch Adsorption oder auf chemischem Weg. Zur Aufnahme des Trocknungsmittels kann der Hohlraum bei Bedarf etwas vergrößert werden.

Neben der Anzeigeeinrichtung selbst betrifft die Erfindung ferner einen Zähler, umfassend eine Zähleinrichtung sowie eine Anzeigeeinrichtung der vorstehend beschriebenen Art.

Dabei ist der Zähler bevorzugt ein Wasserzähler, d. h., dass die Zähleinrichtung dazu ausgelegt ist, die Menge an durchfließendem Wasser sowie gegebenenfalls weitere diesbezüglich relevante Parameter zu erfassen. Es kann sich aber auch um einen Stromzähler, einen Gaszähler, einen Drehzahlzähler und ähnliches Handeln.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine Explosionsdarstellung einer erfindungsgemäßen Anzeigeeinrichtung,
- Fig. 2: die Anzeigeeinrichtung aus Fig. 1 im zusammengebauten Zustand, und
- Fig. 3: die Anzeigeeinrichtung aus Fig. 2 nach Einbringen der Vergussmasse.

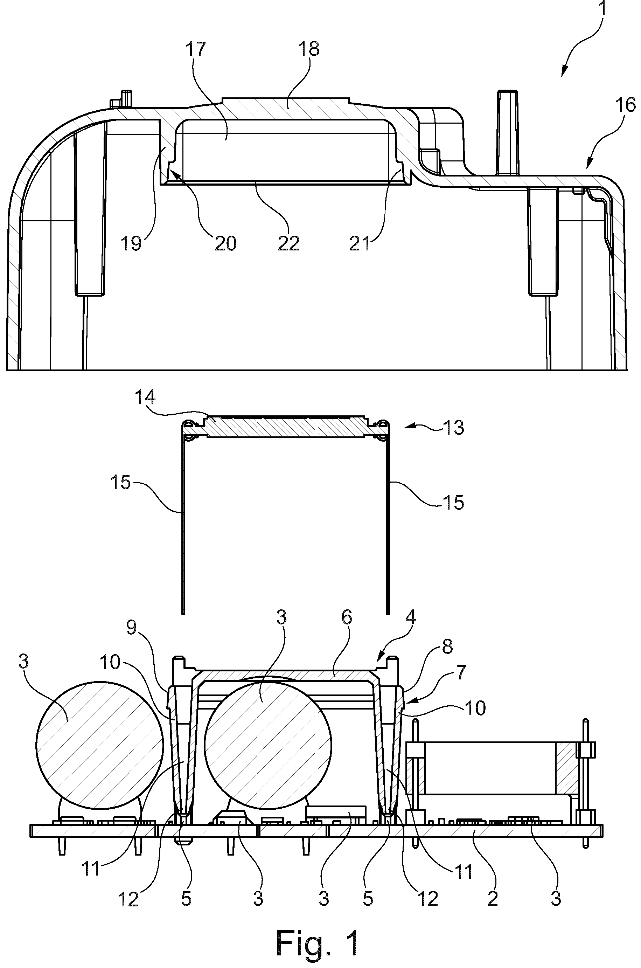

Fig. 1 zeigt eine Explosionsansicht einer erfindungsgemäßen Anzeigeeinrichtung 1. Diese umfasst eine Trägerplatte 2, beispielsweise eine Leiterplatte mit darauf aufgebrachten Kontakt- und Leiterstrukturen. Auf der Trägerplatte 2 sind mehrere elektronische Bauteile 3 angeordnet, bei denen es sich um beliebige elektronische Bauteile wie Batterien oder Akkumulatoren, Kondensatoren, Prozessoren, Speicher etc. handeln kann. Die elektronischen Bauteile 3 sind in geeigneter Weise befestigt und kontaktiert.

An der Trägerplatte 2 ist ferner ein Träger 4, vorzugsweise aus Kunststoff, angeordnet. Der Träger 4 weist entsprechende Befestigungsabschnitte 5 auf, über die er an der Leiterplatte 2 fixiert ist. Er weist ferner einen plattenförmigen Aufnahmeabschnitt 6 auf, auf dem in der Montagestellung ein Anzeigedisplay angeordnet ist.

Der Träger 4 weist einen umlaufenden Dichtabschnitt 7 auf, der dazu ausgelegt ist, in eine umlaufende Dichtanlage an einem entsprechenden Anlagebereich einer nachfolgend beschriebenen Abdeckhaube anzulegen. Der Dichtabschnitt 7 ist als umlaufende Schulter 8 ausgeführt, die sich längs aller vier Seiten des rechteckigen Trägers 4 erstreckt. Die Schulter 8 weist umlaufend eine entsprechende Schrägfläche auf, die ein erleichtertes Einführen und einen formschlüssigen Verbund zur Abdeckhaube erlaubt. An zwei einander gegenüberliegenden Seiten des Trägers 4 sind sich in Richtung der Trägerplatte 2 erstreckende Kanalabschnitte 10 vorgesehen, die jeweils einen oder mehrere Kanäle 11 aufweisen, die der Aufnahme von Kontaktstiften, die an der Anzeigeeinrichtung angeordnet sind, dienen, was nachfolgend noch beschrieben wird. Die Kanäle 11 vergingen sich zur dem zur Trägerplatte 2 benachbarte Ende der Kanalabschnitte 10, wo jeweils eine entsprechende Austrittsöffnung 12 vorgesehen ist, die einen deutlich kleineren Querschnitt aufweist, verglichen zum sonstigen Kanalquerschnitt.

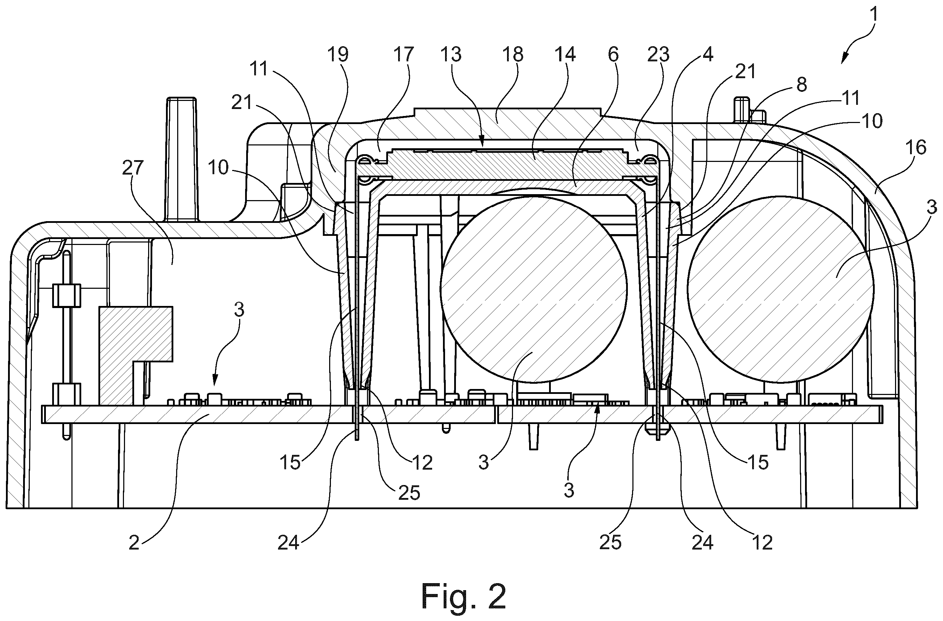

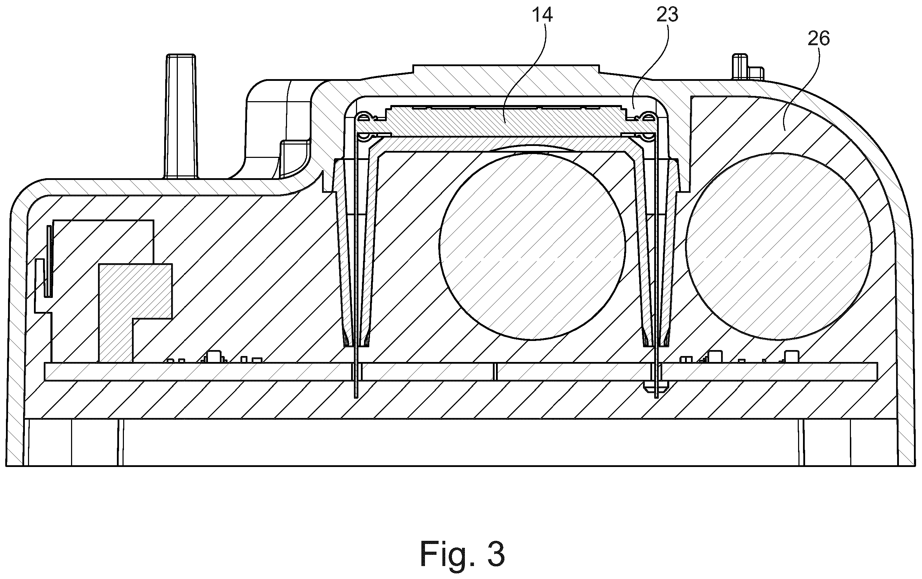

Gezeigt ist ferner ein Anzeigedisplay 13, mit dem eigentlichen Displayteil 14 sowie mehreren an beiden Seiten des Anzeigedisplay vorgesehenen Kontaktstiften 15. In der Montagestellung, die nachfolgend zu den Figuren 2 und 3 beschrieben wird, sind die Kontaktstifte 15 in die Kanäle 11 eingefädelt, sie ragen mit ihren unteren Enden aus den Austrittsöffnungen 12 hervor und greifen in entsprechende Durchbrechungen der Trägerplatte 2 ein. Gleichzeitig liegt das Displayteil 14 auf dem Aufnahmeabschnitt 6 flächig auf.

Schließlich zeigt Fig. 1 eine Abdeckhaube 16, vorzugsweise aus Kunststoff wie beispielsweise PMMA. Die Abdeckhaube 16 weist einen Aufnahmeraum 17 auf, der oberseitig über einen transparenten Bereich 18 der Abdeckhaube 16 begrenzt wird, und seitlich von einer umlaufenden Wandstruktur 19, die in ihrer Querschnittsform exakt der Querschnittsform des Dichtabschnitts 7 bzw. der umlaufenden, über die Schulter 8 gebildeten Dichtstruktur des Trägers 4 entspricht. Die Wandstruktur 19 weist einen umlaufenden Anlagebereich 20 in Form eines Falzes 21 auf, der ebenfalls eine Schrägfläche 22 aufweist, die in Verbindung mit der Schrägfläche 9 der Schulter 8 ein erleichtertes Einführen der Schultern 8 in den Falz 21 erlaubt.

Die geometrische Ausgestaltung und Bemaßung des Dichtabschnitts 7 bzw. der Schulter 8 sowie des Anlageabschnitt 20 bzw. des Falzes 21 ist derart, dass der Dichtabschnitt 7 bzw. die Schulter 8 ein geringes Übermaß von ca. 1/10 mm aufweist, verglichen mit der Bemaßung des Anlageabschnitt 20 bzw. des Falzes 21, sodass beim Fügen der Abdeckhaube 16 der Dichtabschnitt 7 beziehungsweise die Schulter 8 in den Anlagebereich 20 beziehungsweise den Falz 21 eingepresst werden, sich also eine formschlüssige Presspassung ergibt.

Zur Montage wird zunächst das Anzeigedisplay 13 montiert. Hierzu werden die Kontaktstifte 15 in die Kanäle 11 eingefädelt und durchgeschoben, wobei sie dabei aus den Austrittsöffnungen 12 austreten und bei weiterer Bewegung durch entsprechende Durchbrechungen der Trägerplatte 2 geführt werden, im Bereich welche die Kontaktierung erfolgt. Die Aufsetzbewegung ist beendet, wenn das Displayteil 14 auf dem Aufnahmeabschnitt 6 aufliegt. Sodann wird die Abdeckhaube 16 übergestülpt, wobei die Abdeckhaube 16 derart bemessen ist, dass sie auch die Trägerplatte 2 seitlich übergreift und sich über diese hinaus erstreckt. Während dieser Fügebewegung wird der Anlageabschnitt 20 bzw. der Falz 21 auf den Dichtabschnitt 7 bzw. die Schulter 8 aufgeschoben und aufgepresst, wobei dieses Aufschieben und Aufpressen durch die entsprechenden Schrägflächen 9, 22 erleichtert wird, die ein geführtes Einfädeln der Schulter 8 in den Falz 21 erlauben. In der Montageentstellung stößt die Oberkante der Schulter 8 am Rande oder Boden des Falzes 21 an, gleichzeitig liegen die Seitenflächen der Schulter 8 seitlich angepresst an den Seitenflächen des Falzes 21 an. Insgesamt ist also die Schulter 8 in einer formschlüssigen Presspassung im umlaufenden Falls 20 aufgenommen. Hierüber gibt sich eine Dichtanlage, d. h., dass der Träger 4 infolge dieser formschlüssigen Presspassung vollständig umlaufend abgedichtet an der Abdeckhaube 16 anliegt. Das Anzeigedisplay 13 beziehungsweise sein Displayteil 14 ist in dem Aufnahmeraum 17 der Abdeckhaube 16 aufgenommen, wobei sich infolge der beschriebenen Dichtanlage ein abgedichteter Hohlraum 23 ausbildet, in dem das Displayteil 14 aufgenommen ist. Der Hohlraum 23 ist vollständig zur Abdeckhaube 16 hin abgedichtet, lediglich der oder die Kanäle 11 sind über ihre Austrittsöffnungen 12 nach außen hin offen, da hierdurch wie beschrieben die Kontaktstifte 15 greifen.

Die Montagesituation ist in Fig. 2 gezeigt, die eine Schnittansicht durch die Anzeigeeinrichtung 1 zeigt. Dargestellt ist wiederum die Trägerplatte 2 mit den daran angeordneten elektronischen Bauteilen 3 sowie dem Träger 4 samt dem daran angeordneten Anzeigedisplay 13. Die Kontaktstifte 15 sind durch die Kanäle 11 der Kanalabschnitt 10 geführt und treten aus den Austrittsöffnungen 12 nach außen. Ihre Enden 24 greifen durch entsprechende Durchbrechungen 25 der Trägerplatte 2 und werden dort kontaktiert. Das Displayteil 14 liegt auf dem Aufnahmeabschnitt 6 auf.

Der umlaufende Dichtabschnitt 7 bzw. die umlaufende Schulter 8 greift formschlüssig in den umlaufenden Anlagebereich 20 bzw. den umlaufenden Falz 21, sodass sich die beschriebene Presspassung und damit die beschriebene Dichtanlage ergibt. Es bildet sich wie beschrieben der abgedichtete Hohlraum 23 aus, der oberseitig über den transparenten Bereich 18 und seitlich über die Wandstruktur 19 der Abdeckhaube begrenzt wird, und der unterseitig über den Aufnahmeabschnitt 6 sowie den Dichtabschnitt 7 begrenzt wird. Der Hohlraum 23 ist einzig über die im Querschnitt sehr kleinen Austrittsöffnung in 12 nach außen hin offen.

Nachfolgend wird die in Fig. 1 gezeigte Anzeigeeinrichtung 1 mit einer Vergussmasse 26 gefüllt und vergossen. Hierzu wird die in Fig. 3 gezeigte Anordnung beispielsweise um 180° gedreht, so dass die Trägerplatte 2 oben und die Abdeckhaube 16 unten liegt und die fluide Vergussmasse 26 von oben eingebracht werden kann. Wie Fig. 3 zeigt, wird der gesamte Raum 27, der letztlich zwischen der Abdeckhaube 16 und der Trägerplatte 2 gebildet ist, mit der Vergussmasse 26 gefüllt, außer dem Hohlraum 23, in dem das Displayteil 14 aufgenommen ist, der ungefülltes bleibt. Die zunächst fluide oder pastöse Vergussmasse 26 wird in den Raum 27 eingebracht, wobei hierbei sämtliche elektronischen Bauteile 3 vollständig in die Vergussmasse 26 eingebettet werden. Die Vergussmasse 26 breitet sich folglich auch unterhalb des Trägers 4 respektive des Aufnahmeabschnitts 6 aus und füllt den dortigen Raum. Wie beschrieben, sind die Kanäle 11 über die Austrittsöffnung in 12 am unteren Ende offen. Die fluide Vergussmasse, die eine gewisse Zähigkeit aufweist, kann über diese Austrittsöffnung in 12 in die Kanäle eintreten. Die Vergussmasse kann in den Kanälen 11 auch etwas ansteigen, der Anstieg ist jedoch begrenzt. Denn wie beschrieben ist der Hohlraum 23 abgedichtet. In ihm bildet sich demzufolge mit zunehmendem Anstieg der Vergussmasse ein leichter Überdruck aus, da die im Hohlraum 23 enthaltene Luft aus ihm nicht austreten kann. Denn einerseits ist eine Dichtanlage zwischen dem Träger 4 und der Abdeckhaube 16 gegeben, die einen Luftaustritt verhindert. Und andererseits sind die Austrittsöffnung in 12 über die Vergussmasse 26 selbst verschlossen. Der leichte Überdruck begrenzt demzufolge die Anstiegshöhe der Vergussmasse 26 in den Kanälen 11, sodass diese in keinem Fall auf das Niveau des Aufnahmeabschnitts 6 bzw. in den Bereich des Displayteils 14 gelangen kann. Nach Einbringen der Vergussmasse 26 härtet diese vollständig aus, sodass einerseits die gesamte Elektronik vollständig vergossen ist, ebenso auch der Träger und das Anzeigedisplay, gleichermaßen befindet sich das Anzeigedisplay bzw. das Displayteil in einem von Vergussmasse freien Hohlraum, sodass das Displayteil ungehindert über den transparenten Bereich eingesehen werden kann.

Zentrales Merkmal der erfindungsgemäßen Anzeigeeinrichtung ist die direkte Dichtanlage des Trägers 4 an der Abdeckhaube 16, worüber die Ablichtung des Hohlraums 23 erfolgt. Ein separates Dichtmittel ist demzufolge in diesem Bereich nicht aufzubringen, vielmehr erfolgt die Abdichtung unmittelbar zwischen den beteiligten Bauteilen über die Dichtanlage des Dichtabschnitts 7 am Anlagebereich 20 bzw. der umlaufenden Schulter 8 im umlaufenden Falz 21. Dabei ist es denkbar, dass der Dichtabschnitt 7 zusätzlich einen Belag aus einem etwas weicheren Kunststoff als dem Kunststoff des Trägers aufweist, und/oder dass auch der Anlagebereich 20 einen solchen Belag aus einem etwas weicheren Kunststoff als dem der Abdeckhaube 16 aufweist. Ein solcher, sehr dünner Belag kann beispielsweise bei der Herstellung des Trägers 4 und/oder der Abdeckhaube 16 unmittelbar mit aufgebracht bzw. angespritzt werden. Über diesen weichen Belag kann die Dichtanlage und damit die Presspassung noch weiter verbessert werden, sofern überhaupt erforderlich.

### Bezugszeichenliste

- 1: Anzeigeeinrichtung
- 2: Trägerplatte
- 3: elektronisches Bauteil
- 4: Träger
- 5: Befestigungsabschnitt
- 6: Aufnahmeabschnitt
- 7: Dichtabschnitt
- 8: Schulter
- 9: Schrägfläche
- 10: Kanalabschnitt
- 11: Kanal
- 12: Austrittsöffnung
- 13: Anzeigedisplay
- 14: Displayteil
- 15: Kontaktstift
- 16: Abdeckhaube
- 17: Aufnahmeraum
- 18: transparenter Bereich
- 19: Wandstruktur
- 20: Anlagebereich
- 21: Falz
- 22: Schrägfläche
- 23: Hohlraum
- 24: Ende
- 25: Durchbrechung
- 26: Vergussmasse
- 27: Raum

## Patentansprüche

1. Anzeigeeinrichtung, umfassend eine Trägerplatte (2) mit einem oder mehreren darauf angeordneten elektronischen Bauteilen (3), einen Träger (4) für ein Anzeigedisplay (13), ein am Träger (4) angeordnetes Anzeigedisplay (13) sowie eine Abdeckhaube (16), die zumindest in einem das Anzeigedisplay (13) übergreifenden Bereich (18) transparent ist, wobei unterhalb der Abdeckhaube (16) ein abgedichteter Hohlraum (23), in dem das Anzeigedisplay (13) aufgenommen ist, ausgebildet ist, **dadurch gekennzeichnet, dass** der Träger (4) in einer Dichtanlage direkt an der Abdeckhaube (16) anliegt und zwischen der Abdeckhaube (16) und dem Träger (4) dei abgedichtete Hohlraum (23), in dem das Anzeigedisplay (13) angeordnet ist, gebildet ist, wobei der außerhalb des Hohlraums (23) gegebene Raum (27) zwischen der Trägerplatte (2) und der Abdeckhaube (16) mit einer Vergussmasse (26) gefüllt ist.

2. Anzeigeeinrichtung nach Anspruch 1, **dadurch gekennzeichnet, dass** an der Abdeckhaube (16) ein umlaufender Anlagebereich (20) vorgesehen ist, an dem der Träger (4) mit einem ebenfalls umlaufenden Dichtabschnitt (7) anliegt.

3. Anzeigeeinrichtung nach Anspruch 2, **dadurch gekennzeichnet, dass** der Anlagebereich (20) über einen umlaufenden Falz (21) gebildet ist, in den der Träger (4) mit einer den Dichtabschnitt (7) bildenden Schulter (8) eingreift.

4. Anzeigeeinrichtung nach Anspruch 3, **dadurch gekennzeichnet, dass** die Schulter (8) mit einer Presspassung formschlüssig in den Falz (20) eingreift.

5. Anzeigeeinrichtung nach Anspruch 3 oder 4, **dadurch gekennzeichnet, dass** der Falz (21) und/oder Träger (4) zumindest im Bereich des Dichtabschnitts (7) eine Schrägfläche (9, 22) aufweist.

6. Anzeigeeinrichtung nach einem der vorangehenden Ansprüche, **dadurch gekennzeichnet, dass** der Träger (4) aus Kunststoff ist.

7. Anzeigeeinrichtung nach Anspruch 6, abhängig von einem der Ansprüche 2-5, **dadurch gekennzeichnet, dass** der Träger (4)
am Dichtabschnitt (7) einen Belag, der weicher als der den Träger (4) bildende Kunststoff ist, aufweist.

8. Anzeigeeinrichtung nach einem der Ansprüche 2 bis 5 oder 7, oder Anspruch 6 wenn abhängig von einem der Ansprüche 2-5, **dadurch gekennzeichnet,**
**dass** die Abdeckhaube (16) im Anlagebereich (20) einen Belag aufweist, der weicher als der Kunststoff, aus dem die Abdeckhaube 816) gebildet ist, ist.

9. Anzeigeeinrichtung nach einem der vorangehenden Ansprüche, **dadurch gekennzeichnet, dass** der Träger (4) einen oder mehrere Kanäle (11), durch die Kontaktstifte des Anzeigedisplays (13) laufen, die Durchbrechungen (25) in der Trägerplatte (2) durchgreifen, aufweist.

10. Anzeigeeinrichtung nach Anspruch 9, **dadurch gekennzeichnet, dass** sich der Querschnitt des oder der Kanäle (11) zu einer Austrittsöffnung (25), aus der die Kontaktstifte austreten, verjüngt.

11. Anzeigeeinrichtung nach einem der vorangehenden Ansprüche, **dadurch gekennzeichnet, dass** in dem Hohlraum ein Feuchtigkeit bindendes Trocknungsmittel aufgenommen ist.

12. Zähler, umfassend eine Zähleinrichtung sowie eine Anzeigeeinrichtung (1) nach einem der vorangehenden Ansprüche.

13. Zähler nach Anspruch 12, **dadurch gekennzeichnet, dass** es ein Wasserzähler ist.

## Claims

1. Display device, comprising a carrier plate (2) with one or more electronic components (3) arranged thereon, a carrier (4) for a display (13), a display (13) arranged on the carrier (4), and a cover (16), which is transparent at least in a region (18) covering the display (13), wherein there is formed beneath the cover (16) a sealed cavity (23) in which the display (13) is accommodated, **characterized in that** the carrier (4) abuts the cover (16) directly in sealing abutment, and the sealed cavity (23), in which the display (13) is arranged, is formed between the cover (16) and the carrier (4), wherein the space (27) that is present outside the cavity (23) between the carrier plate (2) and the cover (16) is filled with a potting compound (26).

2. Display device according to Claim 1, **characterized in that** there is provided on the cover (16) a peripheral abutment region (20), which the carrier (4) abuts with a likewise peripheral sealing portion (7).

3. Display device according to Claim 2, **characterized in that** the abutment region (20) is formed by a peripheral rebate (21), into which the carrier (4) engages with a shoulder (8) that forms the sealing portion (7).

4. Display device according to Claim 3, **characterized in that** the shoulder (8) engages into the rebate (20) in a positive manner with a press fit.

5. Display device according to Claim 3 or 4, **characterized in that** the rebate (21) and/or the carrier (4) has a sloping surface (9, 22) at least in the region of the sealing portion (7).

6. Display device according to one of the preceding claims, **characterized in that** the carrier (4) is made of plastics material.

7. Display device according to Claim 6, dependent on one of Claims 2-5, **characterized in that** the carrier (4) has in the sealing portion (7) a coating which is softer than the plastics material forming the carrier (4).

8. Display device according to one of Claims 2 to 5 or 7, or Claim 6 when dependent on one of Claims 2-5, **characterized in that** the cover (16) has in the abutment region (20) a coating which is softer than the plastics material of which the cover 816) is formed.

9. Display device according to one of the preceding claims, **characterized in that** the carrier (4) has one or more channels (11) through which there extend contact pins of the display (13) which engage through through-holes (25) in the carrier plate (2).

10. Display device according to Claim 9, **characterized in that** the cross section of the channel(s) (11) tapers to an outlet opening (25) from which the contact pins emerge.

11. Display device according to one of the preceding claims, **characterized in that** a moisture-binding drying agent is accommodated in the cavity.

12. Meter, comprising a counting device and a display device (1) according to one of the preceding claims.

13. Meter according to Claim 12, **characterized in that** it is a water meter.

## Revendications

1. Dispositif d'affichage comprenant une plaque de support (2) sur laquelle sont disposés un ou plusieurs composants électroniques (3), un support (4) pour un écran d'affichage (13), un écran d'affichage (13) disposé sur le support (4) ainsi qu'un capot de recouvrement (16), qui est transparent au moins dans une zone (18) chevauchant l'écran d'affichage (13), une cavité (23) étanche, dans laquelle est logé l'écran d'affichage (13), étant formée sous le capot de recouvrement (16), **caractérisé en ce que** le support (4) repose directement sur le capot de recouvrement (16) en appui étanche et la cavité (23) étanche, dans laquelle l'écran d'affichage (13) est disposé, est formée entre le capot de recouvrement (16) et le support (4), l'espace (27) existant à l'extérieur de la cavité (23) entre la plaque de support (2) et le capot de recouvrement (16) étant rempli d'une masse de scellement (26).

2. Dispositif d'affichage selon la revendication 1, **caractérisé en ce qu'**est prévue sur le capot de recouvrement (16) une zone d'appui (20) périphérique, sur laquelle le support (4) repose par une section d'étanchéité (7) également périphérique.

3. Dispositif d'affichage selon la revendication 2, **caractérisé en ce que** la zone d'appui (20) est formée par un pli (21) périphérique, avec lequel le support (4) vient en prise par un épaulement (8) formant la section d'étanchéité (7).

4. Dispositif d'affichage selon la revendication 3, **caractérisé en ce que** l'épaulement (8) vient en prise par complémentarité de forme avec le pli (20) par un ajustement serré.

5. Dispositif d'affichage selon la revendication 3 ou 4, **caractérisé en ce que** le pli (21) et/ou le support (4) comportent une surface oblique (9, 22) au moins dans la zone de la section d'étanchéité (7).

6. Dispositif d'affichage selon l'une des revendications précédentes, **caractérisé en ce que** le support (4) est en matière plastique.

7. Dispositif d'affichage selon la revendication 6, lorsqu'elle dépend de l'une des revendications 2 à 5, **caractérisé en ce que** le support (4) comporte, sur la section d'étanchéité (7), un revêtement qui est plus mou que la matière plastique formant le support (4).

8. Dispositif d'affichage selon l'une des revendications 2 à 5 ou 7, ou selon la revendication 6 lorsqu'elle dépend de l'une des revendications 2 à 5, **caractérisé en ce que** le capot de recouvrement (16) comporte, dans la zone d'appui (20), un revêtement qui est plus mou que la matière plastique à partir de laquelle le capot de recouvrement 816) est formé.

9. Dispositif d'affichage selon l'une des revendications précédentes, **caractérisé en ce que** le support (4) comporte un ou plusieurs canaux (11), à travers lesquels passent des broches de contact de l'écran d'affichage (13), lesquelles traversent des ajours (25) dans la plaque de support (2).

10. Dispositif d'affichage selon la revendication 9, **caractérisé en ce que** la section transversale du ou des canaux (11) se rétrécit en une ouverture de sortie (25) de laquelle sortent les broches de contact.

11. Dispositif d'affichage selon l'une des revendications précédentes, **caractérisé en ce qu'**un dessiccant fixant l'humidité est logé dans la cavité.

12. Compteur comprenant un dispositif de comptage ainsi qu'un dispositif d'affichage (1) selon l'une des revendications précédentes.

13. Compteur selon la revendication 12, **caractérisé en ce qu'**il est un compteur d'eau.
